# EUROPEAN PATENT SPECIFICATION

(11) **EP 1 345 484 B1**
(45) Date of publication and mention of the grant of the patent: **08.06.2005**
(21) Application number: 03004409.3
(22) Date of filing: 27.02.2003
(51) Int. Cl.: H05K 7/14

(54) **Backplane system with non-standard signals**
Rückwandplatinensystem mit Nichtstandardsignalen
Système de fond de panier avec des signaux non standard

(30) Priority: 05.03.2002 US 92052
(43) Date of publication of application: 17.09.2003
(73) Proprietor: ALCATEL, 75008 Paris (FR)
(72) Inventor: Linares, Ignacio A., Plano, Texas 75075 (US); Gammenthaler, Robert S., Jr., Frisco, Texas 75035 (US); Dubois, Gerald R., Richardson, Texas 75080 (US)
(74) Representative: Rausch, Gabriele, Dr.

(56) References cited:
- WO-A-01/55868
- WO-A-02/069076

## Description

### BACKGROUND OF THE INVENTION

### Technical Field of the Invention

The present invention generally relates to backplane technologies. More particularly, and not by way of any limitation, the present invention is directed to a system and method for introducing non-standard, e.g., proprietary, signals into a standard backplane.

### Description of Related Art

The exponential increase in the number of local telephone lines, mobile subscribers, pages, fax machines, and other data devices, e.g., computers, Information Appliances, etc., coupled with deregulation that is occurring worldwide today is driving demand for small form factor, high capacity switching nodes (e.g., Signal Transfer Points or STPs) which must be easy to maintain, provide full SS7 functionality with so-called "five nines" operational availability (i.e., 99.999% uptime), and provide the capability to support future functionality or features as the need arises. Further, as subscriber demand for more service options proliferates, an evolution is taking place in the telecommunications industry to integrate Intelligent Network (IN)-capable Service Control Point (SCP) functionality within STP nodes to give rise to what are known as "signaling server" nodes that have integrated or hybrid functionality.

Additionally, coupled with the phenomenal popularity of the Internet, there has been a tremendous interest in using the packet-switched network (PSN) infrastructure employed in the data networks (e.g., those based on Internet Protocol (IP) addressing) as a replacement for, and/or as an adjunct to, the existing circuit-switched network (CSN) infrastructure deployed in today's voice networks. Several advantages are expected to be realized due to such integration. From network operators' viewpoint, the inherent traffic aggregation in PSN allows for a reduction in the cost of transmission and the infrastructure cost per end-user. Ultimately, such cost reductions enable the network operators to pass on the savings to subscribers. Also, operators of a new breed of service-centric networks (collectively referred to as the Next-Generation Network or NGN infrastructure, distinct from the existing voice-centric and data-centric networks) can offer enhanced services with integrated voice/data/video to subscribers who will be using endpoints of diverse multimedia capabilities.

While it is generally expected that a single platform that supports large-database, high-transaction IN services as well as high-capacity packet switching will reduce equipment costs, reduce network facility costs and other associated costs while increasing economic efficiency, those skilled in the art should recognize that several difficulties must be overcome in order to integrate the requisite functionalities into a suitable network element that satisfies the stringent performance criteria required of carrier-class, telecom-hardened network equipment. Daunting challenges arise in designing a compact enough form factor that is efficiently scalable, ruggedized, and modularized for easy maintenance, yet must house an extraordinary array of complex electronic circuitry, e.g., processors, control components, timing modules, I/O, line interface cards which couple to telephony networks, etc., that is typically required for achieving the necessary network element functionality. Whereas the electronic components may themselves be miniaturized and modularized into cards or boards that can be interconnected, supporting the requisite functionality within a stringent form factor on a backplane poses many obstacles.

Advances in backplane technology have accordingly become very important in the context of today's telecommunications network equipment. Clearly, providing a standardized backplane with a rugged form factor and connectorization, including a standard bus path across the backplane, is critical to the overall equipment design. Additionally, such standardization is necessary for ensuring interoperability of off-the-shelf components developed by third-party suppliers. As an example of the technical background, reference is made to the dual bridge carrier card as described in WO 01/55868 A1.

Whereas the emergence of standards-compliant backplanes and associated bus technologies (e.g., the Compact Peripheral Component Interconnect (CPCI) bus standard) has been laudatory, the need for continuous improvement nevertheless remains in this important field. For example, current standard backplanes support only a limited number of signal pathways that span the entire backplane and these signal pathways (collectively, the bus) are typically confined to carrying standards-compliant bus signals to the various cards connected thereto. However, it should be apparent to those skilled in the art that in many applications it may be desirable and/or necessary to increase the number of such pathways so that additional signals (e.g., application-specific control signals) may be carried thereon across the backplane. Further, such a solution for providing the carrying capacity for additional signals should not so interfere with the bus standard employed that it effectively precludes interoperability with the compliant off-the-shelf cards.

### SUMMARY OF THE INVENTION

Accordingly, the present invention advantageously provides an innovative solution for introducing user-defined (e.g., proprietary) signals into a standard backplane such as a CPCI-compliant backplane without sacrificing compliance requirements or negatively interfering with the use of third-party card components. In addition to a standardized connectorization scheme, at least one of the front side connector segments or at least one of the rear side connector segments is provided with additional non-standard connector holes, thereby forming an extra-wide segment. The inclusion of extra contact points in a connector segment allows for supporting an independent signal pathway to carry one or more user-defined signals across the backplane, in addition to the standard bus signals, without sacrificing compliance with the applicable bus standard.

In one aspect, the present invention is directed to a backplane that supports proprietary signals in addition to standards-compliant signals. A front side portion is provided with a plurality of front connector holes organized into a set of standardized front connector segments. The backplane's rear side portion is provided with a plurality of rear connector holes organized into a set of rear connector segments that substantially correspond to the front connector segments. Preferably, at least one rear connector segment includes a set of non-standard rear connector holes that are disposed in addition to the standard rear connector holes. The non-standard rear connector holes of the rear connector slots are operable to support a signal pathway through the backplane independent of a standard bus path supported by at least one of the standardized front connector segments.

In another aspect, the present invention is directed to a method for introducing user-defined signals into a CPCI-compliant backplane, comprising the following steps: providing a front side portion of the backplane with a plurality of front connector holes that are organized into a set of standardized front connector segments, wherein at least one of the standardized front connector segments is operable to support a CPCI-compliant bus for carrying CPCI signals; and providing a rear side portion of the backplane with a plurality of rear connector holes that are organized into a set of rear connector segments which substantially correspond to the front connector segments, wherein at least one rear connector segment includes a set of non-standard rear connector holes that are disposed in addition to the standard rear connector holes such that they can be interconnected to support a signal pathway independent of the CPCI-compliant bus.

In a further aspect, the present invention is directed to a connector system that includes a CPCI-compliant backplane having a plurality of slots. Each slot includes five front side connector segments (denoted herein as P1 through P5) and five rear side connector segments (denoted herein as rP1 through rP5) that correspond to the front side connector segments. In accordance with the features of an exemplary implementation, at least one of the P1/P2 connector segments or rP1/rP2 segments is provided with a set of non-standard connector holes operable to support a proprietary bus through the backplane. A front side card is coupled to the backplane at a particular slot, wherein the front side card is operable to carry a plurality of CPCI signals via a front side backplane bus formed to couple the P1 and P2 connector segments of the slots. A rear side card is coupled to the backplane at the particular slot's rear side connector segments, wherein the rear side card is operable to carry at least one user-defined signal via the proprietary bus (e.g., a rear side backplane bus) formed to couple the rP1 and rP2 segments of the slots.

### BRIEF DESCRIPTION OF THE DRAWINGS

A more complete understanding of the present invention may be had by reference to the following Detailed Description when taken in conjunction with the accompanying drawings wherein:

FIG. 1 depicts a CPCI-compliant connector arrangement having a backplane and associated front side and rear side cards;

FIGS. 2A and 2B depict two exemplary connectorization schemes available for use with a CPCI backplane;

FIG. 3 depicts exemplary P1/P2 connector portions of a CPCI backplane for conventional operation;

FIG. 4A depicts a high-level signal pathway scheme in a conventional CPCI connector arrangement;

FIG. 4B depicts a conventional solution for providing proprietary signals in a CPCI connector system;

FIG. 5A depicts an exemplary CPCI-compliant backplane embodiment for introducing user-defined signals in addition to CPCI bus signals in accordance with the teachings of the present invention;

FIG. 5B depicts another exemplary CPCI-compliant backplane embodiment for introducing user-defined signals in addition to CPCI bus signals in accordance with the teachings of the present invention;

FIG. 6 depicts a view of an exemplary CPCI-compliant backplane with non-standard connector segments for supporting a proprietary signal pathway; and

FIG. 7A depicts an exemplary embodiment of a CPCI connector system provided in accordance with the teachings of the present invention; and

FIG. 7B depicts another exemplary embodiment of a CPCI connector system provided in accordance with the teachings of the present invention.

### DETAILED DESCRIPTION OF THE DRAWINGS

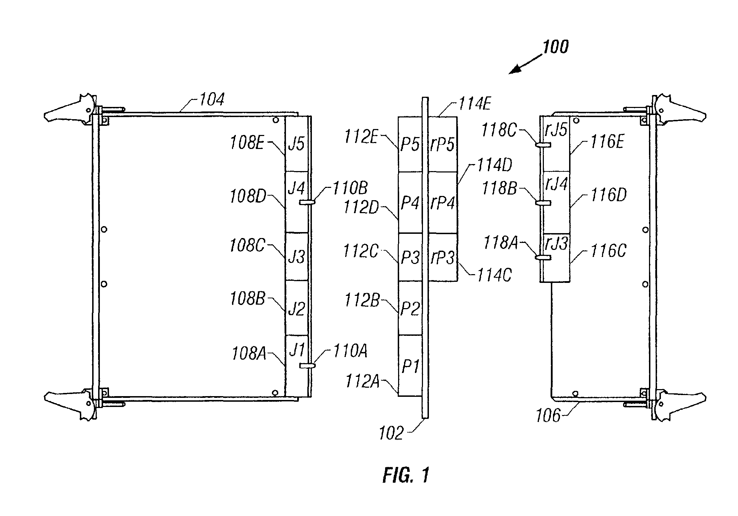

In the drawings, like or similar elements are designated with identical reference numerals throughout the several views thereof, and the various elements depicted are not necessarily drawn to scale. Referring now to FIG. 1, depicted therein is a conventional CPCI-compliant connector arrangement 100 which is provided as an exemplary backplane system wherein the teachings of the present invention can be advantageously practiced for providing user-defined signal pathways in addition to a standards-based bus system (e.g., CPCI bus). The exemplary connector arrangement 100 includes a CPCI-compliant backplane 102 operable to receive cards from both front and rear sides. Accordingly, a front side card 104 and its corresponding rear side card 106 are provided by way of illustration. As is well-known, CompactPCI® is an adaptation of the Peripheral Component Interconnect (PCI) Specification 2.1 or later for industrial and/or embedded applications requiring a more robust mechanical form factor than desktop PCI. CompactPCI uses industry standard mechanical components and high performance connector technologies to provide an optimized bus/backplane system intended for rugged applications such as telecommunications equipment.

As a bus standard, CompactPCI is maintained by the PCI Industrial Computer Manufacturers Group (PICMG®). It defines a combination of the electrical and logical specifications of the PCI Standard and the mechanical specifications of the Institute of Electrical and Electronics Engineers (IEEE) 1101 and the International Electromechanical Committee (IEC) 60297 series of standards. For enhanced functionality, two-sided connectorization is provided whereby a backplane supporting a standards-compliant bus is operable to couple to a front side card portion as well as to a rear side card portion associated therewith. The form factor defined for CompactPCI is based on the Eurocard form factor as defined in IEC 60297-3 and IEC 60297-4 and extended by IEEE 1101.10. Typically, the board format is provided as either a 3U (100 mm by 160 mm) or 6U (233.35 mm by 160 mm) Eurocard. For a 3U card, a two-segment connector scheme is specified. That is, each slot on the backplane and the corresponding connector mates on front and rear side cards are segmented into two portions. These segments are conventionally numbered J1 and J2 on the front side card panel, P1 and P2 on the backplane's front side connector slot, rP1 and rP2 on the backplane's rear side connector slot, and rJ1 and rJ2 on the rear side card panel (which is also referred to as a transition module or TM in some applications).

The front side card panel 104 and associated rear side card panel 106 of the connector arrangement 100 exemplify a 6U board format wherein a five-segment connector scheme is provided. Reference numerals 108A through 108E refer to the five connector segments (J1-J5) provided for the front side card panel 104. Similar to the 3U connector scheme, P1 through P5 refer to the corresponding backplane connector portions (reference numerals 112A through 112E) on the front side of the backplane 102. In a typical implementation, J1/P1 and J2/P2 connector segments are operable to support a CPCI standard bus that spans the backplane, which bus interconnects the J1/P1 and J2/P2 segments of the backplane slots. Up to eight slots may be provided, in general, wherein the J1/P1 arrangement is utilized for supporting a 32-bit CPCI bus. A 64-bit, extended CPCI bus arrangement is supported by utilizing both J1/P1 and J2/P2 segments. The remaining connector segments, i.e., J3/P3, J4/P4 and J5/P5 segments, are used for input/output (I/O) signals that traverse from the front side card panel 104 to the rear side card panel 106, which I/O signals are required to be compliant with the applicable CPCI standards. Since no I/O signals traverse from the front side to the rear side using J1/P1 or J2/P2 segments in the exemplary embodiment shown, the backplane 102 is not provided with rear side connector segments rP1 and rP2 that correspond to the P1 and P2 front side segments. Rather, only rP3-rP5 segments (reference numerals 114C-114E) and corresponding rJ3-rJ5 segments (reference numerals 116C-116E) are provided on the backplane's rear side and the real panel, respectively.

Continuing to refer to FIG. 1, the front side card panel 104 and associated rear side card panel 106 may each be provided with one or more alignment features at prescribed locations on the respective connector slots. For instance, reference numerals 110A and 110B refer to two alignment features provided with respect to the front side card panel 104. In similar fashion, three alignment features 118A-118C are provided for the rear side card panel 106.

As is well-known, the alignment features may be provided as part of the connector housings and, depending on connectorization, their location can be specific to one or more of the connector segments. Three housing types are common: Type A, Type B and Type AB. Type A connector segments have alignment features as well as certain coding keys. Type B connector segments are plain and have no such features or keys. Type AB connectors, on the other hand, have alignment features but no coding keys.

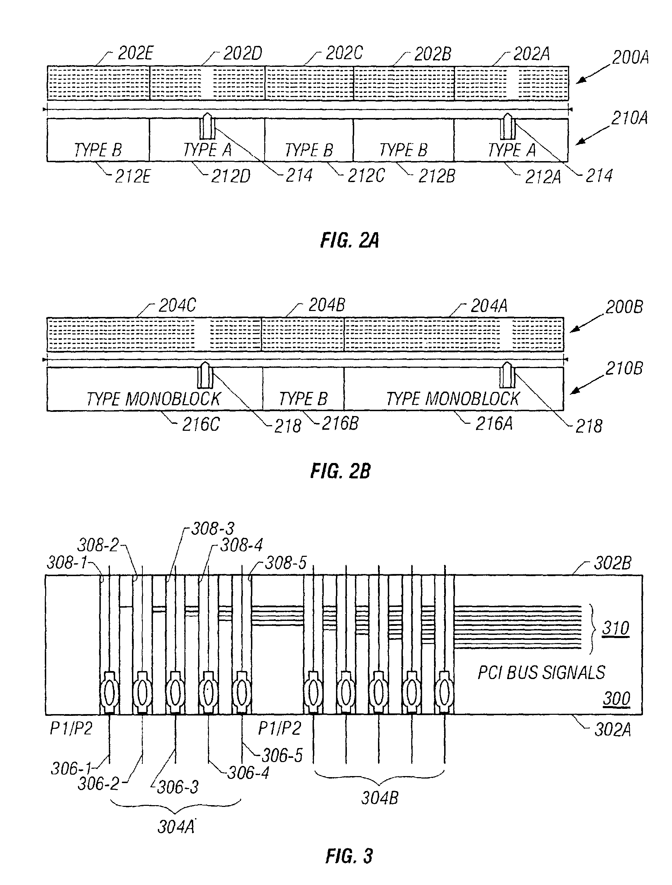

FIGS. 2A and 2B show two exemplary connectorization schemes available for use with a CPCI backplane operable to receive 6U cards. Reference numerals 200A and 200B refer to two backplane slot embodiments, each having a particular connectorization scheme. In the exemplary embodiments shown, not only is the placement of the alignment features variable but two adjacent connector segments may be combined into a single block. Reference numerals 210A and 210B refer to the connector slot housings on the cards that correspond to the backplane slots 200A and 200B.

With respect to the slot arrangement 200A, the five connector segments 202A-202E are separately identified, with segments 202A and 202D having appropriate spaces that accommodate the alignment features 214 of the card connector 210A. Reference numerals 212A-212E refer to the five segments of the card connector 210A, which correspond to the J1-J5 segments discussed above. A Type A connector housing is provided for segments 212A and 212D. A Type B connector housing is provided for remaining three segments.

With respect to the slot arrangement 200B, two top connector segments and two bottom connector segments are combined into separate monoblocks, thereby resulting in only three partitions. Reference numerals 204A-204C refer to the three partitions, wherein each of the partitions 204A and 204C is a combination of two connector segments. The corresponding card connector 210B is accordingly provided with monoblock connector housings 216A and 216C for mating with partitions 204A and 204C, each monoblock having a card alignment feature 218. A Type B connector housing is provided for the segment 216B.

Referring now to FIG. 3, shown therein is a top view of a standard backplane 300 having a conventional arrangement of the P1/P2 connector segments. Reference numerals 304A and 304B exemplify the P1/P2 segments of two slots on the backplane 300 having a front side portion 302A and a rear side portion 302B. Each connector segment is 5-contact wide, i.e., it is operable in association with a 5-pin-wide card connector. Reference numerals 306-1 through 306-5 refer to five contact pins having long spills that couple to the corresponding connector holes 308-1 through 308-5 of the backplane 300. As pointed out earlier, the P1/P2 connector segments 304A and 304B support CPCI bus signals carried on a standard bus which is exemplified by a plurality of signal paths 310 interconnecting the slots 304A and 304B.

Conventionally, the entire inner surface of the P1/P2 connector holes may be plated with appropriate conductive material in order to ensure proper electrical contact with the pins. Where necessary, a shroud may be placed on the rear side portion 302B of the backplane 300 in order to couple to the long spills of the contact pins.

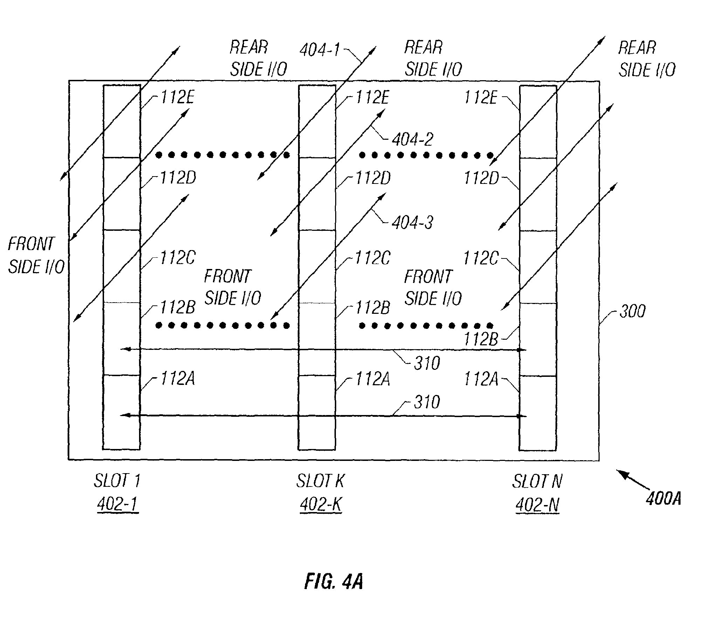

FIG. 4A depicts a high-level signal pathway scheme in a conventional CPCI connector arrangement 400A. A plurality of slots (reference numerals 402-1 through 402-N) are provided on the exemplary CPCI backplane 300. Each slot is preferably provided with the standard P1-P5 connectorization described hereinabove. Reference numeral 310 again refers to the CPCI-compliant bus path that interconnects the P1/P2 segments of the slots for carrying CPCI bus signals. With particular reference to one exemplary slot, Slot K (reference numeral 402-K), three illustrative I/O signal paths 404-1 through 404-3 are disposed between the front side I/O and rear side I/O connectors (i.e., P3/rP3-P5/rP5 segments) of the backplane 300 for carrying CPCI-compliant I/O signals.

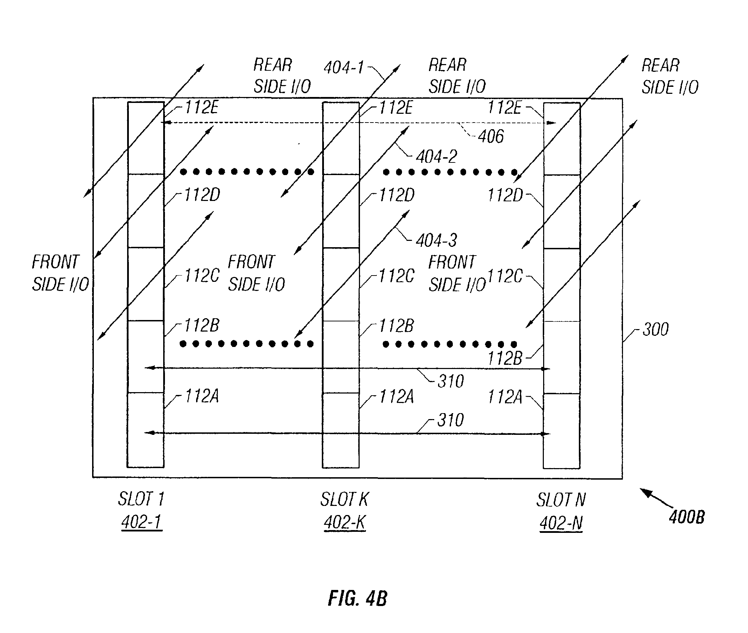

FIG. 4B depicts a conventional solution for providing proprietary signals in a CPCI connector system 400B. As set forth above, the connector system 400B is operable to carry the CPCI-compliant bus signals on the path 310 disposed on the backplane 300. Further, in addition to the standard front-to-rear I/O connectivity, a separate signal path 406 may be provided along the backplane 300 using one of the I/O connectors (i.e., J3/P3 though J5/P5) for carrying one or more user-defined signals (e.g., proprietary signals). However, as pointed out in the Background section of the present patent application, such an arrangement is not satisfactory because it can conflict with the I/O signal space of off-the-shelf CPCI cards.

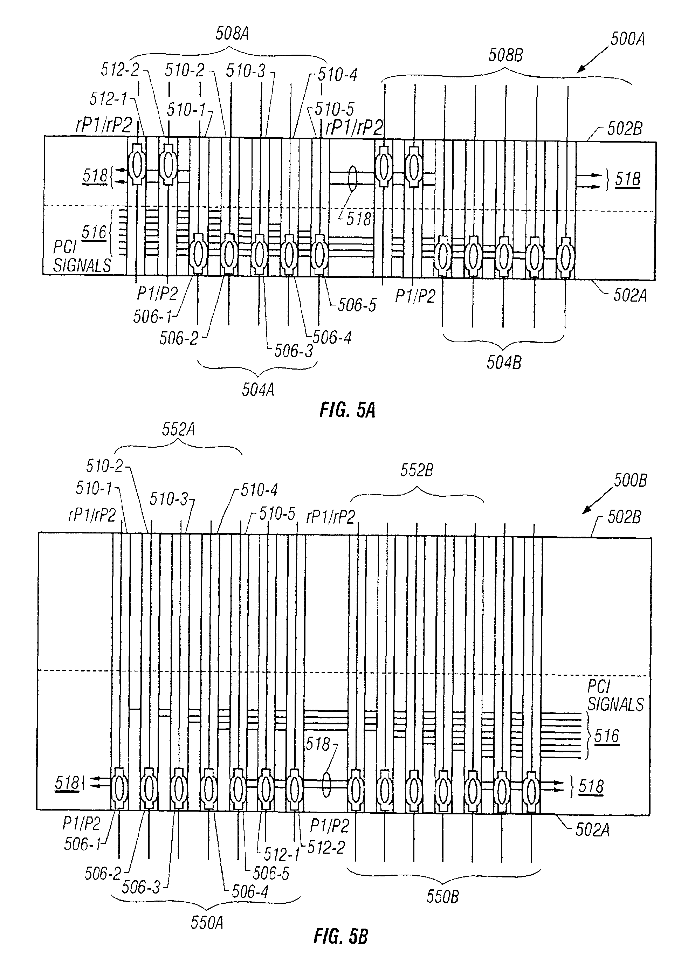

Referring now to FIG. 5A, depicted therein is an exemplary CPCI-compliant backplane embodiment 500A for introducing user-defined signals in addition to CPCI bus signals in accordance with the teachings of the present invention. A front side portion 502A is provided with a plurality of front connector holes that are organized into a set of standardized front connector segments, wherein P1/P2 connector segments for two exemplary slots 504A and 504B are illustrated. Connector holes 506-1 through 506-5 exemplify the front connector holes for the P1/P2 connector segments of the present invention that are operable to couple to the corresponding J1/J2 connector contacts of a front side card panel (not shown). A rear side portion 502B of the backplane 500A is provided with a plurality of rP1/rP2 connector segments 508A and 508B corresponding to the front side connectors, which rear side connectors are modified as will be set forth below.

In the exemplary embodiment shown in FIG. 5A, the rP1 and rP2 connector segments are provided with a set of standard rear connector holes for coupling with rJ1 and rJ2 portions of an off-the-shelf rear side card panel (not shown) that may have such connector portions, or for coupling with a shroud in some applications. For instance, reference numerals 510-1 through 510-5 refer to the exemplary standard rear connector holes of the rP1/rP2 segment 508A, which connector holes are operable to couple to a shroud or the contacts of a corresponding rJ1/rJ2 segment.

In accordance with the teachings of the present invention, one or both of the rear side connector segments (i.e., rP1/rP2 segments) are modified so as to accommodate additional pins that carry user-defined signals from a custom rear side card panel. That is, the rear side connector segments 508A and 508B are provided with extra rear connector holes, preferably organized as one or more additional columns depending on the form factor requirements, which extra connector holes are operable to receive the additional, non-standard pins of a rear side connector. Reference numerals 512-1 and 512-2 exemplify such non-standard connector holes provided for the rear side portion 502B of the backplane 500A. Where the rear side non-standard connector holes are provided as feed-through holes (as shown in this FIG.), the corresponding front side connector segment (i.e., P1 or P2) will have additional columns of non-standard holes which can be mated with a blanking shroud so as not to interfere with the operation of the standard J1/J2 connector contacts of the front side card panel (not shown). In an alternative implementation, the non-standard rear side connector holes 512-1 and 512-2 may be dimensioned such that ultrashort PCI-compliant contacts may be received therein (i.e., feed-to holes). Additional details regarding the ultrashort PCI-compliant contacts may be found in the following commonly owned co-pending patent application entitled "System And Method For Introducing Proprietary Signals Into A Standard Backplane Via Physical Separation," Application No. , filed , in the names of: Ignacio A. Linares, Robert S. Gammenthaler, Jr., and Gerald R. Dubois (Attorney Docket No.: 1285-0082US), which is hereby incorporated by reference herein.

The P1/P2 segments of the front connector slots are conventionally operable to support a CPCI-compliant signal path 516 which is effectuated by interconnecting the plural front side P1/P2 connector segments. Additionally, the non-standard rear connector holes of the rear side rP1/rP2 connector segments may be interconnected via appropriate backplane layering to form a secondary signal pathway 518, wherein one or more non-standard connector holes of a connector segment may be electrically coupled thereto depending on the number of signals to be carried (i.e., carrying capacity). The signal pathway 518 is therefore operable to carry proprietary signals on the rear side portion of the backplane 500A, which is not used by the standard rear side cards. Accordingly, it should be appreciated that the present invention advantageously allows the introduction of one or more user-defined signals in a standard backplane system without compromising the electrical and/or form factor requirements of off-the-shelf boards.

FIG. 5B depicts another exemplary CPCI-compliant backplane embodiment 500B for introducing user-defined signals in addition to CPCI bus signals in accordance with the teachings of the present invention, wherein the non-standard connectorization is provided for the front side connector segments, i.e., P1 and P2 connector segments. Similar to the exemplary embodiment described above, *mutatis mutandis,* the front side portion 502A includes modified front connector P1 and/or P2 segments. Reference numerals 550A and 550B refer to two illustrative front slots with modified P1/P2 segments, wherein non-standard connector holes 512-1 and 512-2 are exemplified in addition to standard front connector holes 506-1 through 506-5. Again, the standardized portion of the front side P1/P2 segments is operable to support the CPCI-compliant bus 516. The non-standard connector holes of the front side P1/P2 connector segments can be interconnected to form the secondary signal pathway 518. Additionally, the front side non-standard connector holes may be provided as feed-through holes (as shown in this FIG.) or feed-to holes to accommodate ultrashort compliant contacts.

It should be appreciated based on the foregoing that the non-standard connectorization may be provided either on the front side (in P1 and/or P2 segments) or on the rear side (in rP1 and/or rP2 segments) of the backplane. Also, whereas the non-standard connector holes have been illustrated as feed-through holes that span the entire thickness of the backplane, they may be provided as ultrashort-compliant holes as well, where they accommodate feed-to connectors. Further, the relative placement of the CPCI-compliant bus 516 and the proprietary bus 518 may vary depending on the backplane layering technology as well as the intended application. The two buses can therefore occupy either the rear side portion or the front side portion of the backplane, or any combination thereof. Moreover, the non-standard connector holes may be provided on either side of the standard connector segments of each slot, depending on form factor requirements.

Various proprietary signals may be advantageously carried on the secondary signal bus path created on the backplane of the present invention. In telecom network equipment applications where the present invention may be advantageously employed, e.g., in a signaling server rack, several application-specific system control signals and status signals may be carried on the proprietary bus of the backplane in addition to the standard CPCI bus signals across a number of line cards. For example, a Super Frame Indicator (SFI) signal operable to control the overall operation of a Next-Generation STP, or an Extended Alarm Signal (EAS) operable to encode the STP's line card alarm/status information may be carried on the secondary bus path created in accordance herewith. Additional details regarding these and other related proprietary signals may be found in the following commonly owned co-pending patent application entitled "Clock Distribution Scheme In A Signaling Server," Application No.: 09/541,002, filed March 31, 2000, in the name(s) of: Val Teodorescu, which patent application has been cross-referenced hereinabove.

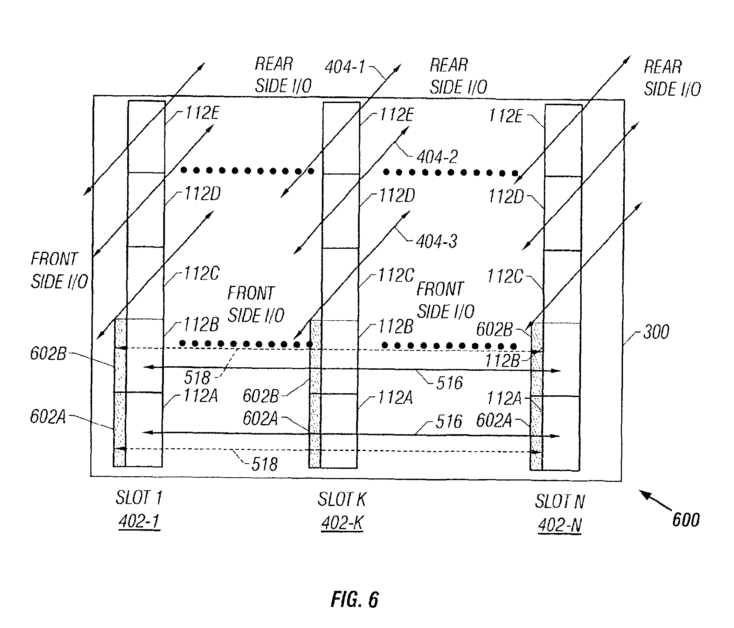

FIG. 6 depicts a view of an exemplary CPCI-compliant backplane arrangement 600 with non-standard connector segments for supporting a proprietary signal pathway. It should be apparent that the view shown in FIG. 6 is similar to the view shown in FIG. 4A, except that the P1/rP1 and P2/rP2 connector segments 112A and 112B have been expanded to illustrate the wider connectorization for including additional contact holes. Reference numerals 602A and 602B refer to the non-standard portions of the wider P1/rP1 and P2/rP2 connector segments of the plural slots disposed on the backplane 600. Whereas the standard CPCI bus portions 516 are formed by interconnecting the standardized portions of the connector segments 112A and 112B, the proprietary bus portions 518 are formed by interconnecting the non-standard portions thereof.

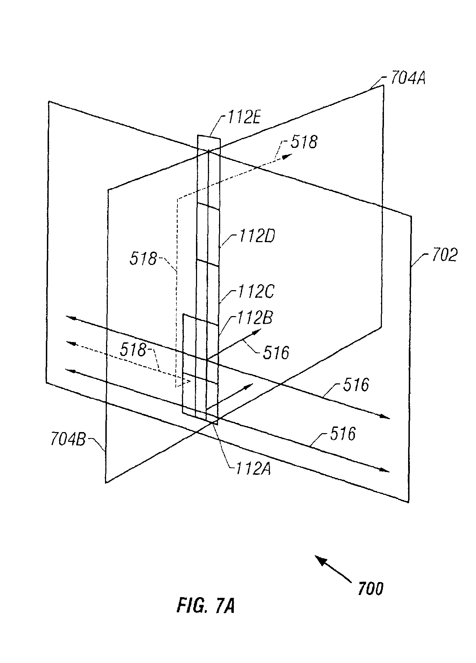

FIG. 7A depicts an exemplary embodiment of a CPCI connector system 700 provided in accordance with the teachings of the present invention. Reference numeral 702 refers to a backplane having a non-standard connectorization portion for its P1/rP1 segment 112A, P2/rP2 segment 112B, or both, as set forth above. Reference numerals 704A and 704B refer to exemplary front side and rear side card panels, respectively. Standard PCI signals are operable to be carried on the CPCI bus 516 supported by the front P1/P2 segments. The proprietary signals may be carried on the secondary bus 518 on the rear side (i.e., rP1 and/or rP2 segments with extra connector holes) of the backplane 702, which signals can traverse the rear side card 704B and be provided to the front side card 704A via a standard I/O connector segment, e.g., rP5/P5 segment 112E.

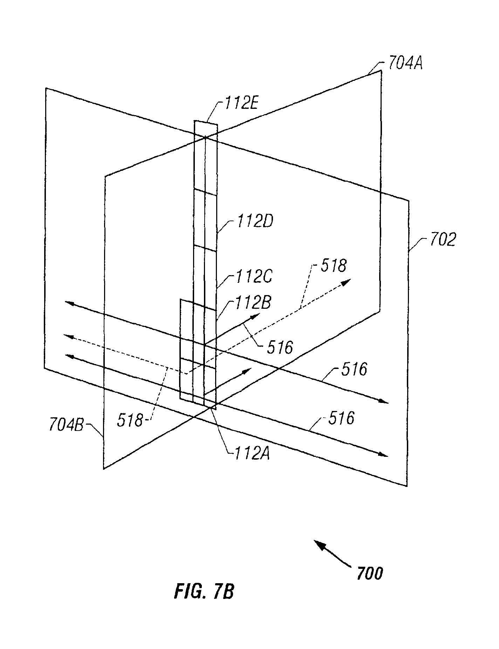

FIG. 7B depicts another exemplary embodiment of the CPCI connector system 700 provided in accordance with the teachings of the present invention, wherein the secondary bus 518 is effectuated via the non-standardized portion of the front side connector. The proprietary signals can therefore be provided directly to the front side card panel 704A from the backplane 702 without having to be routed via the rear side card panel 704B and a separate I/O connector segment.

Based upon the foregoing Detailed Description, it should be apparent that the present invention advantageously provides an innovative and efficient solution for introducing user-defined signals in a standard CPCI backplane system without precluding the use of standard third-party CPCI cards. By providing such capability in a telecom application environment, the design and performance of network equipment can be greatly enhanced.

It is believed that the operation and construction of the present invention will be apparent from the foregoing Detailed Description. While the exemplary embodiments of the invention shown and described have been characterized as being preferred, it should be readily understood that various changes and modifications could be made therein without departing from the scope of the present invention as set forth in the following claims. For instance, although the teachings of the present invention have been particularly exemplified in a CPCI connector environment, those skilled in the art should recognize that user-defined signals may be introduced in any standards-compliant backplane system in accordance herewith. Thus, the teachings of the present invention are amenable for practice with respect to such applications as VME, MultiBus and Eurocard systems, in addition to 9U-based CPCI applications. Further, the non-standard connectorization of the backplane connectors may be effectuated in any known or heretofore unknown manner, so long as such connectorization is operable to support a proprietary bus either in the rear side portion or in the front side portion of the backplane without interfering with the normal operation. Furthermore, in other embodiments, the holes may be continuous front-to-rear (i.e., feed-through holes), but may have electrical separation by way of insulated inner wall portions. In still further embodiments, there may be a "spacer" sandwiched between the front and rear side portions of the backplane whereby the front connector holes are electrically separated from the rear connector holes. It should therefore be understood that these and other various modifications, alterations, revisions, amendments, additions, deletions, combinations, and the like are within the ambit of the present invention whose scope is limited solely by the following claims.

## Claims

1. A connector system, comprising:
a Compact Peripheral Component Interconnect (CPCI)-compliant backplane (102) having a plurality of slots, each slot including five front side connector segments (denoted herein also as P1 through P5 connector segments) and five rear side connector segments (denoted herein also as rP1 through rP5 connector segments) that substantially correspond to said front side connector segments, wherein at least one of said P1 and P2 connector segments is operable to support a CPCI-compliant bus and further wherein at least one of said rP1 and rP2 connector segments is provided with a set of non-standard connector holes in addition to standard rear connector holes;
a front side card (104) coupled to said backplane at a particular slot, said front side card operating to carry a plurality of CPCI signals via said CPCI-compliant bus formed to interconnect said P1 and P2 connector segments of said slots; and
a rear side card (106) coupled to said backplane (102) at said particular slot's rear side connector segments, said rear side card operating to carry at least one user-defined signal via a rear side backplane bus formed to interconnect said non-standard connector holes of said rP1 and rP2 connector segments of said slots.

2. The connector system as set forth in claim 1, wherein said at least one user-defined signal is provided from said rear side card (106) to said front side card (104) via a coupling between said P3 and rP3 connector segments.

3. The connector system as set forth in claim 1, wherein said at least one user-defined signal is provided from said rear side card (106) to said front side card (104) via a coupling between said P4 and rP4 connector segments.

4. The connector system as set forth in claim 1, wherein said at least one user-defined signal is provided from said rear side card (106) to said front side card (104) via a coupling between said P5 and rP5 connector segments.

5. The connector system as set forth in claim 1, wherein said at least one user-defined signal comprises a Super Frame Indicator (SFI) signal operable to control the operation of a telecommunications rack in which said backplane is deployed.

6. The connector system as set forth in claim 1, wherein said at least one user-defined signal comprises an Extended Alarm Signal (EAS) operable to carry a plurality of alarms generated in the operation of a telecommunications rack in which said backplane is deployed.

7. The connector system as set forth in claim 1, wherein said P1 and P2 connector segments are formed as a monoblock.

8. The connector system as set forth in claim 1, wherein said P4 and P5 connector segments are formed as a monoblock.

9. The connector system as set forth in claim 1, wherein said non-standard rear connector holes are dimensioned to receive ultrashort press-in pins formed at a corresponding connector portion of said rear side card (106).

## Patentansprüche

1. Steckverbindersystem, umfassend:
eine CPCI-konforme (Compact Peripheral Component Interconnect) Rückwandplatine (102), die eine Vielzahl von Einbauplätzen aufweist, wobei jeder Einbauplatz fünf vorderseitige Steckverbindersegmente (die hier ebenfalls als Steckverbindersegmente P1 bis P5 bezeichnet sind) und fünf rückseitige Steckverbindersegmente (die hier ebenfalls als Steckverbindersegmente rP1 bis rP5 bezeichnet sind) beinhaltet, die im Wesentlichen den vorderseitigen Steckverbindersegmenten entsprechen, wobei mindestens eines der Steckverbindersegmente P1 und P2 funktionsfähig ist, um einen CPCI-konformen Bus zu unterstützen, und außerdem wobei mindestens eines der Steckverbindersegmente rP1 und rP2 mit einem Satz von Nichtstandard-Steckverbinderlöchern zusätzlich zu den hinteren Standard-Steckverbinderlöchern bereitgestellt wird;
eine vorderseitige Karte (104), die mit der Rückwandplatine an einem speziellen Einbauplatz gekoppelt ist, wobei die vorderseitige Karte in Betrieb ist, um eine Vielzahl von CPCT-Signalen über den CPCI-konformen Bus zu unterstützen, der gebildet wird, um die Steckverbindersegmente P1 und P2 der Einbauplätze miteinander zu verbinden; und
eine rückseitige Karte (106), die mit der Rückwandplatine (102) an den rückseitigen Steckverbindersegmenten des speziellen Einbauplatzes gekoppelt ist, wobei die rückseitige Karte in Betrieb ist, um mindestens ein anwenderdefiniertes Signal über einen rückseitigen Rückwandplatinenbus zu übertragen, der gebildet wurde, um die Nichtstandard-Steckverbinderlöcher der Steckverbindersegmente rP1 und rP2 der Einbauplätze miteinander zu verbinden.

2. Steckverbindersystem nach Anspruch 1, in welchem mindestens ein anwenderdefiniertes Signal von der rückseitigen Karte (106) an die vorderseitige Karte (104) über eine Kopplung zwischen den Steckverbindersegmenten P3 und rP3 bereitgestellt wird.

3. Steckverbindersystem nach Anspruch 1, in welchem mindestens ein anwenderdefiniertes Signal von der rückseitigen Karte (106) an die vorderseitige Karte (104) über eine Kopplung zwischen den Steckverbindersegmenten P4 und rP4 bereitgestellt wird.

4. Steckverbindersystem nach Anspruch 1, in welchem mindestens ein anwenderdefiniertes Signal von der rückseitigen Karte (106) an die vorderseitige Karte (104) über eine Kopplung zwischen den Steckverbindersegmenten P5 und rP5 bereitgestellt wird.

5. Steckverbindersystem nach Anspruch 1, in welchem mindestens ein anwenderdefiniertes Signal ein SFI-Signal (Super Frame Indicator) umfaßt, das funktionsfähig ist, um den Betrieb eines Telekommunikationsgestelles zu steuern, in welchem die Rückwandplatine verwendet wird.

6. Steckverbindersystem nach Anspruch 1, in welchem mindestens ein anwenderdefiniertes Signal ein EAS-Signal (Extended Alarm Signal) umfaßt, das funktionsfähig ist, um eine Vielzahl von Alarmen zu übertragen, die während des Betriebs eines Telekommunikationsgestelles erzeugt wurden, in welchem die Rückwandplatine verwendet wird.

7. Steckverbindersystem nach Anspruch 1, in welchem die Steckverbindersegmente P1 und P2 als ein Monoblock gebildet werden.

8. Steckverbindersystem nach Anspruch 1, in welchem die Steckverbindersegmente P4 und P5 als ein Monoblock gebildet werden.

9. Steckverbindersystem nach Anspruch 1, in welchem die hinteren Nichtstandard-Steckverbinderlöcher so dimensioniert sind, um ultrakurze Einpreßstifte aufzunehmen, die an einem entsprechenden Steckverbinderabschnitt der rückseitigen Karte (106) gebildet wurden.

## Revendications

1. Système de connecteurs, comprenant :
un fond de panier conforme au CPCI (d'interconnexion de composants périphériques compacts) (102) possédant une pluralité d'encoches, chaque encoche comprenant cinq segments de connecteurs avant (indiqués également ici comme les segments de connecteurs P1 à P5) et cinq segments de connecteurs arrière (indiqués également ici comme les segments de connecteurs rP1 à rP5) qui correspondent sensiblement auxdits segments de connecteurs avant, dans lequel au moins l'un desdits segments de connecteurs P1 et P2 peut supporter un bus conforme au CPCI, et dans lequel au moins l'un desdits segments de connecteurs rP1 et rP2 est muni d'un ensemble de trous de connecteurs non standard en plus des trous de connecteurs arrière standard ;
une carte avant (104) couplée audit fond de panier au niveau d'une encoche particulière, ladite carte avant fonctionnant pour acheminer une pluralité de signaux CPCI via ledit bus conforme au CPCT formé afin d'interconnecter lesdits segments de connecteurs P1 et P2 desdites encoches ; et
une carte arrière (106) couplée audit fond de panier (102) au niveau desdits segments de connecteurs arrière de ladite encoche particulière, ladite carte arrière fonctionnant pour acheminer au moins un signal défini par l'utilisateur via un bus de fond de panier arrière formé afin d'interconnecter lesdits trous de connecteurs non standard desdits segments de connecteurs rP1 et rP2 desdites encoches.

2. Système de connecteurs selon la revendication 1, dans lequel ledit signal défini par l'utilisateur au moins est fourni par ladite carte arrière (106) à ladite carte avant (104) via un couplage entre lesdits segments de connecteurs P3 et rP3.

3. Système de connecteurs selon la revendication 1, dans lequel ledit signal défini par l'utilisateur au moins est fourni par ladite carte arrière (106) à ladite carte avant (104) via un couplage entre lesdits segments de connecteurs P4 et rP4.

4. Système de connecteurs selon la revendication 1, dans lequel ledit signal défini par l'utilisateur au moins est fourni par ladite carte arrière (106) à ladite carte avant (104) via un couplage entre lesdits segments de connecteurs P5 et rP5.

5. Système de connecteurs selon la revendication 1, dans lequel ledit signal défini par l'utilisateur au moins comprend un signal SFI (signal indicateur de supertrame) pouvant contrôler le fonctionnement d'un rack de télécommunications dans lequel ledit fond de panier est déployé.

6. Système de connecteurs selon la revendication 1, dans lequel ledit signal défini par l'utilisateur au moins comprend un signal EAS (signal d'alarme étendu) pouvant acheminer une pluralité d'alarmes générées lors du fonctionnement d'un rack de télécommunications dans lequel ledit fond de panier est déployé.

7. Système de connecteurs selon la revendication 1, dans lequel lesdits segmenta de connecteurs P1 et P2 sont formés comme un monobloc.

8. Système de connecteurs selon la revendication 1, dans lequel lesdits segments de connecteurs P4 et P5 sont formés comme un monobloc.

9. Système de connecteurs selon la revendication 1, dans lequel lesdits trous de connecteurs arrière non standard sont dimensionnés afin de recevoir des broches à pression ultracourtes formées au niveau d'une partie de connecteur correspondante de ladite carte arrière (106).
